Europäisches Patentamt

European Patent Office

Office européen des brevets

(11) Publication number: **0 346 775**
**A1**

## EUROPEAN PATENT APPLICATION

(21) Application number: **89110494.5**

(22) Date of filing: **09.06.89**

(51) Int. Cl.⁴: **G11B 20/14** , **H03M 5/02**

(30) Priority: **14.06.88 US 206646**

(43) Date of publication of application:
**20.12.89 Bulletin 89/51**

(84) Designated Contracting States:
**ES**

(71) Applicant: **EASTMAN KODAK COMPANY (a New Jersey corporation)**
**343 State Street**
**Rochester New York 14650(US)**

(72) Inventor: **Wash, Michael Lee c/o EASTMAN KODAK COMPANY**
**Patent Department 343 State Street**
**Rochester New York 14650(US)**

(74) Representative: **Blickle, K. Werner, Dipl.-Ing. et al**
**KODAK AKTIENGESELLSCHAFT Postfach 600345**
**D-7000 Stuttgart-Wangen 60(DE)**

(54) **Method for modulating a binary data stream.**

(57) A method for modulating a binary data stream into a code format suitable for encoding information that employs a non-return-to-zero (NRZ) technique. The method consisting in: (1) defining a bitcell as the time t between two adjacent clock transitions; (2) writing a first clock transition at the beginning of the bitcell; and (3) encoding a binary data transition in the ratio of td/t, where td is the time duration between the first clock tansition and the data transition, with the proviso that td/t ≠ 1/2. Preferably, the ratio td/t < 1/2 encodes a data 0 bit, and the ration td/t > 1/2 encodes a data 1 bit. The method is specially advantageously employed where the information transfer rate is dependent on unpredicable and variable transfer rate velocities and accelerations.

FIG. 1

## METHOD FOR MODULATING A BINARY DATA STREAM

### CROSS-REFERENCE TO RELATED APPLICATIONS

This application is related to Application Ser. No. 206,408 filed June 14, 1988, by Whitfield et al., Application Ser. No. 206,407 filed June 14, 1988, by Wash, and Application Ser. No. 206,553 filed June 14, 1988, by Whitfield, which Applications are being filed contemporaneously with this application. The entire disclosures of each of these applications are incorporated by reference herein. Each of these applications is copending and commonly assigned.

### FIELD OF THE INVENTION

This invention relates to a method for modulating a binary data stream into a code format suitable for encoding and decoding information.

### INTRODUCTION TO THE INVENTION

Methods for encoding and decoding binary information or data extend to such disparate fields as e.g., magnetic systems or optical systems. The methods include the step of storing a binary 0 or 1 on a small area of material or medium. Storage is dynamic, for the medium on which the information is recorded typically moves past a reading or writing device, or vice versa. Typically, in writing information on a medium surface, the binary information is supplied to a recording circuitry, which then codes this information into a pattern which is recorded by a writing device. The techniques which are used to write information on the medium include the two well-known categories: the return-to-zero (RZ) techniques, and the non-return-to-zero (NRZ) techniques. Useful methods for reading information using either technique also vary and are well known. Reference may be made, for example, to the Handbook authored by Jorgensen entitled THE COMPLETE HANDBOOK OF MAGNETIC RECORDING, (1980) published by Tab Books Inc., Blue Ridge Summit, PA.

The process for encoding and decoding binary information is not straightforward, and considerable attention has been given to both the recording patterns used to represent data 0 and 1 bits, and the means for determining the value recorded. Clearly, the reading and writing procedures should be as reliable as is possible.

### SUMMARY OF THE INVENTION

As indicated above, the process for encoding and decoding binary information typically is dynamic, for the medium on which the information is recorded may move past a reading or writing device, or vice versa. The stated objective of reliability has been realized for this situation in systems where the information transfer rate is well-regulated e.g., disk drive, optical disk, or streaming tape. Here, the decoded information bits can be precisely positioned in a time opening known as a data window. If a bit is present in the data window, the decoded bit is a 1. If no bit is present in the data window, the bit is a zero.

In sharp contrast to this situation in which the information transfer rate is well regulated, is that situation where the information transfer rate is not, or cannot be, well-controlled i.e., the transfer rate is dependent on unpredictable and variable transfer rate velocities and accelerations. For example, magnetic credit card readers fit into this last situation. Here, the prior art encoding and decoding techniques may require the employment of expensive, multiple writing and/or reading devices, or fail or cease to provide a desired reliability.

I have discovered a novel method for modulating a binary data stream into a code format suitable for encoding and decoding binary information. The novel method fits into the non-return-to-zero (NRZ) techniques which are used to write information on a medium. The novel method can be employed for the first situation where the information transfer rate is well-regulated. It is especially advantageously employed for the second situation, where the information transfer rate may be dependent on unpredictable and variable transfer rate velocities and accelerations. The novel method has the advantage of requiring the employment of only one writing or reading device, thus considerably reducing the expense of the presently required multiple reading and writing devices. At the same time, the novel method realizes the stated objective of reliability.

In a first aspect, the invention provides a method for modulating a binary data stream into a three-part code format, which method comprises:

(1) defining a bitcell as the time t between two adjacent clock transitions;

(2) writing a first clock transition at the beginning of the bitcell; and

(3) encoding a binary data transition after the first clock transition in the ratio of

$$\frac{t_d}{t} \, ,$$

where $t_d$ is the time duration between the first clock transition and the data transition, with the proviso that

$$\frac{t_d}{t} \neq \frac{1}{2} .$$

Preferably, the ratio

$$\frac{t_d}{t} < \frac{1}{2}$$

encodes a data 0 bit, and the ratio

$$\frac{t_d}{t} > \frac{1}{2}$$

encodes a data 1 bit. A particularly useful embodiment provides a ratio

$$\frac{t_d}{t} \approx \frac{1}{3}$$

to encode a data 0 bit, and the ratio

$$\frac{t_d}{t} \approx \frac{2}{3}$$

to encode a data 1 bit. The usefulness of this last embodiment derives from the fact that, within the context of the method, it provides optimal data bit discrimination. The method can also be employed by providing a ratio

$$\frac{t_d}{t} < \frac{1}{2}$$

to encode a data 1 bit, and the ratio

$$\frac{t_d}{t} > \frac{1}{2}$$

to encode a data 0 bit.

Preferably, the clock transitions are assigned a first identifiable characteristic, and the data transition a second identifiable characteristic. For example, an identifiable characteristic suitable for magnetic systems may be that of polarity, so that the clock transitions are the opposite polarity of the data transition. For example, the clock transition may have a positive polarity and the data transition may have a negative polarity, or vice versa. For optical systems, on the other hand, a suitable characteristic may be that of color, so that a clock transition could be assigned a light-to-dark transition, and a data transition have an assigned dark-to-light transition, or vice versa. In the same manner, a suitable characteristic in other appropriate systems can include readily differentiated changes, like transmissivity or absorption. In all cases, this feature of identifiable characteristics uniquely differentiates the clock transitions from the data transition. Consequently, this feature helps provide "self-clocking", which, in turn, permits velocity insensitive encoding.

This last concept, i.e., self-clocking and velocity insensitive encoding, highlights an important advantage of the novel method. The concept is also usefully understood by considering the case of a succession of bitcells. In the general case, the time $t_1$ between two adjacent clock transitions of a first bitcell, may differ from the time $t_2$ between two adjacent clock transitions of a second bitcell. This is a consequence of the information transfer rate being dependent on unpredictable and variable transfer rate velocities and accelerations. It should be clear, therefore, that if one employed an external, invariant clocking mechanism to indicate the advent of a bitcell, it would shortly be out of synchronization with the variable time dependent bitcell succession. The novel method, in sharp contrast, overcomes this problem by way of self-clocking i.e., no matter when a bitcell occurs, the clock transition defines the bitcell initiation, and is, at the same time, distinguished from the varying time location of the data transition for that bitcell.

This first aspect of the method may further comprise a step of decoding the encoded binary data stream, by determining the time between the first clock transition and the data transition, and comparing this time to the bitcell time.

In a second aspect, the invention provides a method for modulating a binary data stream into a three-part code format, which method comprises:

(1) defining a bitcell as the space S between two adjacent clock transitions;

(2) writing a first clock transition at the beginning of the bitcell; and

(3) encoding a binary data transition after the first clock transition so that a data 0 bit is located in the first half of the bitcell space S, and a data 1 bit is located in the second half of the bitcell space S, or vice versa.

In a third aspect, the invention provides a method for modulating a binary data stream into a three-part code format, which method comprises:

(1) defining a bitcell as the time t between two adjacent clock transitions;

(2) writing a first clock transition at the beginning of the bitcell; and

(3) encoding a binary data transition after the first clock transition in the ratio of

$$\frac{t_d}{t},$$

where $t_d$ is the time duration between the first clock transition and the data transition, with the proviso that the ratio distinguishes a data 1 bit from a data 0 bit.

This third aspect of the method of the invention recites a different proviso, and demonstrates that the bitcell ratio

$$\frac{t_d}{t} \neq \frac{1}{2}$$

is a particular case of a generalized ratio

$$\frac{t_d}{t} \neq \frac{1}{n}.$$

The point of the proviso, in all cases, is to avoid an ambiguity that may prevent the distinguishing of a data 1 bit from a data 0 bit. By generalizing the ratio from $\frac{1}{2}$ to $\frac{1}{n}$ the argument is made that a "line of demarcation" can eliminate the possible ambiguity between the data 1 bit and the data 0 bit, and that the line of demarcation can be made at any point $\frac{1}{n}$ within a bitcell. Now, having established the "no ambiguity rule" that

$$\frac{t_d}{t} \neq \frac{1}{n},$$

the encoding locates a data 0 transition according to $t_d < \frac{t}{n}$ and a data 1 transition according to $t_d > \frac{t}{n}$ (or vice versa). In the same way, the decoding proceeds by determining that if

$$\frac{t_d}{t} < \frac{1}{n},$$

then a data 0 bit has been encoded, and if

$$\frac{t_d}{t} > \frac{1}{n},$$

then a data 1 bit has been encoded (or vice versa).

In a fourth aspect, the invention provides a method comprising:

(1) providing a composition comprising a photographic film,

(2) accelerating the composition to a transport velocity; and

(3) encoding a binary data stream into a three-part code format for writing said data stream onto the composition, the encoding being insensitive to the composition velocity, said encoding comprising the steps of:

(a) defining a bitcell as the time t between two adjacent clock transitions;

(b) writing a first clock transition at the beginning of the bitcell; and

(c) encoding a binary data transition after the first clock transition in the ratio of

$$\frac{t_d}{t},$$

where $t_d$ is the time duration between the first clock transition and the data transition, with the proviso that

$$\frac{t_d}{t} \neq \frac{1}{n},$$

where $\frac{1}{n}$ defines a line of demarcation between a data 0 bit and a data 1 bit.

Preferably, the composition comprises a magnetic recording material.

Preferred compositions are in the form of a tape. A suitable composition for employment in the present method is disclosed in U.S. Pat. Nos. 3,782,947, 4,613,911, U.K. Application No. 2,083,652A, and the publication entitled DataKode Magnetic Control Surface, Eastman Kodak Company, 1983. The disclosure of each of these publications and applications is incorporated herein by reference.

## BRIEF DESCRIPTION OF THE DRAWING

The invention is illustrated in the accompanying drawing, in which

FIG. 1 shows, in a generalized fashion, the three-part code concept,

FIGS. 2 and 3 illustrate the method encoding and decoding schemes, respectively, for a magnetic system, and

FIG. 4 illustrates the method as used in an optical system.

## DETAILED DESCRIPTION OF THE INVENTION

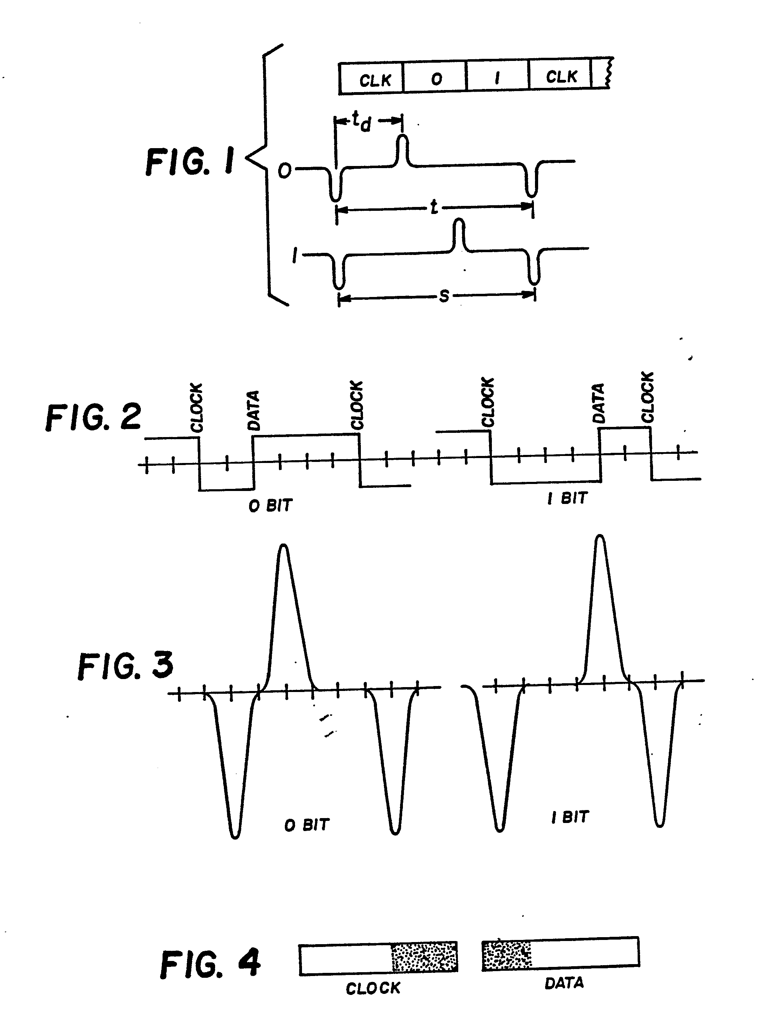

Attention is now directed to FIG. 1, which shows, in a generalized fashion, the three-part code concept of the invention. FIG. 1 shows two adjacent clock transitions ($CLK_1$ and $CLK_2$), with a data 0 bit and a data 1 bit located between the two clock transitions. The time t defines the time between the two adjacent clock transitions. The time t thus defines the bitcell. The time t also corresponds to the space S between the two adjacent clock transitions. FIG. 1 further shows a pulse representation of a data 0 bit and a data 1 bit. Both the data 0 bit and the data 1 bit are encoded, according to the method of the invention, after the first clock transition, and in the ratio of

$$\frac{t_d}{t},$$

where $t_d$ is the time duration between the first clock transition and the data transition. FIG. 1, in particular, shows that the ratio

$$\frac{t_d}{t} < \frac{1}{2}$$

encodes the data 0 bit, and the ratio

$$\frac{t_d}{t} > \frac{1}{2}$$

encodes the data 1 bit. Looked at from the second aspect of the invention, Fig. 1 also shows the data 0 bit located in the first half of the bitcell space S, and the data 1 bit located in the second half of the bitcell space S.

FIG. 1 helps illustrate a particularly important advantage of the method of the invention discussed above. Namely, the clock transitions are "built-in" to the encoding scheme. This feature means that the encoding can be self-clocking i.e., velocity insensitive. In a general situation, this means that the information transfer rate is not bounded. In a practical situation, the information rate can change more than 10-25%, in particular greater than 100%, especially greater than 1000%, from a first bitcell to a second adjacent bitcell.

Attention is now directed to FIG. 2, which shows an encoding scheme suitable for a magnetic system and in accordance with the method of the invention. Consider first the case for a data 0 bit. Here, the data 0 bit is encoded by first writing a clock transition at the beginning of the bitcell. The information or data i.e., the 0 bit, then follows. The data 0 bit is shown here as a transition written 33% of the time of the bitcell, shown by way of six equally spaced hatch marks, with the data 0 bit written through two of the hatch marks. In other words,

$$\frac{t_d}{t} = \frac{1}{3}.$$

Now consider an encoding scheme for the case of a data 1 bit. Here, the data 1 bit is encoded by first writing a clock transition at the beginning of the bitcell. The information or data i.e., the 1 bit, then follows. The data 1 bit is shown here as a transition written 67% of the time t of the bitcell, shown by way of six equally spaced hatch marks, with the 1 bit written through four of the hatch marks.

In other words,

$$\frac{t_d}{t} = \frac{2}{3}.$$

Note that for both the data 0 bit and the data 1 bit, the clock transitions are the opposite polarity of the data transition. FIG. 2 shows that the clock transitions are negative, and the data transitions are positive. In other embodiments, not shown, this representation may be reversed, so that the clock transitions are positive and the data transitions are negative. The advantage of this representation is that it provides an easily decoded clock which cannot be confused with data, for each bitcell, and regardless of a variable or unpredictable information transfer rate.

Attention is now directed to FIG. 3, which shows a decoding scheme suitable for a magnetic system and in accordance with the method of the invention. The data or information, 0 bit or 1 bit, may be decoded by determining the time between the data transition and the preceding clock transition, and comparing this time to the bitcell time. If the data transition occurs in the first half of the bitcell, the data bit is a 0 bit. On the other hand, if the data transition occurs in the second half of the bitcell, the data bit is a 1 bit.

Preferred electrical circuits that may be employed for realizing the encoding and decoding schemes of FIGS. 2 and 3 are disclosed in the Application Ser. Nos. 206,407, 206,408, and 206,553, cross-referenced above.

Attention is now directed to FIG. 4 which illustrates the method as used in an optical system. FIG. 4 shows a clock transition is assigned a light-to-dark transition, and a data transition is assigned a dark-to-light transition. In other embodiments, not shown, this representation may be reversed, so that the clock transition is assigned a light-to-dark transition, and the data transition is assigned a dark-to-light transition.

## Claims

1. A method for modulating a binary data stream into a three-part code format, which method is characterized by

(1) defining a bitcell as the time t between two adjacent clock transitions;

(2) writing a first clock transition at the beginning of the bitcell; and

(3) encoding a binary data transition after the first clock transition in the ratio

$$\frac{t_d}{t} ,$$

where

$$\frac{t_d}{t}$$

is the time duration between the first clock transition and the data transition, with the proviso that the ratio distinguishes a data 1 bit from a data 0 bit.

2. A method according to claim 1, wherein said ratio $t_d/t \neq 1/n$, where $1/n$ defines a line of demarcation between a data 0 bit and a data 1 bit.

3. A method according to claim 1, wherein said data transition after said first clock transition is so that a data 0 bit is located in the first half of the bitcell, and a data 1 bit is located in the second half of the bitcell, or vice versa.

4. A method according to claim 1, wherein n = 2, and the ratio

$$\frac{t_d}{t} < \frac{1}{2}$$

encodes a data 0 bit, and the ratio

$$\frac{t_d}{t} > \frac{1}{2}$$

encodes a data 1 bit.

5. A method according to claim 1, wherein n = 2, and the ratio

$$\frac{t_d}{t} \cong \frac{1}{3}$$

encodes a data 0 bit, and the ratio

$$\frac{t_d}{t} \cong \frac{2}{3}$$

encodes a data 1 bit.

6. A method according to claim 1, wherein n = 2, and the ratio

$$\frac{t_d}{t} < \frac{1}{2}$$

encodes a data 1 bit, and the ratio

$$\frac{t_d}{t} > \frac{1}{2}$$

encodes a data 0 bit.

7. A method according to claim 1, wherein the clock transitions are assigned a first identifiable characteristic, and the data transition is assigned a second identifiable characteristic.

8. A method according to claim 7, wherein the identifiable characteristic is polarity, and the clock transitions are the opposite polarity of the data transition.

9. A method according to claim 8, wherein the clock transitions have a negative polarity and the data transition has a positive polarity.

10. A method according to claim 1, comprising a plurality of bitcells, at least one of which bitcells has a time $t_1$ between two adjacent clock transitions, which time $t_1$ is different from a time $t_2$ between two adjacent clock transitions of a second bitcell.

11. A method according to claim 1, further comprising the step of decoding the encoded binary data stream, by determining the time between the first clock transition and the data transition, and comparing this time to the bitcell time.

12. A method according to claims 1 through 11, characterized in that said method is used for recording said binary data stream on a recording medium.

13. A method according to claim 12, wherein said recording medium is a photographic film or a magnetic recording material or an optical recording material.

FIG. 1

FIG. 2

O BIT          I BIT

FIG. 3

O BIT          I BIT

FIG. 4

CLOCK          DATA

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | GB-A-1 542 398  (SECRETARY OF STATE FOR DEFENCE LONDON) * page 1, lines 70-77; page 2, lines 39-63,72-93; figure 3d * | 1-12 | G 11 B   20/14 H 03 M    5/02 |
| A | ----- | 13 | |

TECHNICAL FIELDS SEARCHED (Int. Cl.4)

G 11 B   20/00
H 03 M    5/00

The present search report has been drawn up for all claims

| Place of search | Date of completion of the search | Examiner |
|---|---|---|
| BERLIN | 08-09-1989 | CHAUMERON B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)